(19) Europäisches Patentamt
European Patent Office
Office européen des brevets

(11) **EP 3 639 046 B1**

(12) **FASCICULE DE BREVET EUROPEEN**

(45) Date de publication et mention
de la délivrance du brevet:
**11.11.2020 Bulletin 2020/46**

(21) Numéro de dépôt: **18727810.6**

(22) Date de dépôt: **01.06.2018**

(51) Int Cl.:
**G01R 31/11** (2006.01)

(86) Numéro de dépôt international:
**PCT/EP2018/064414**

(87) Numéro de publication internationale:
**WO 2018/228826 (20.12.2018 Gazette 2018/51)**

(54) **PROCEDE ET DISPOSITIF DE DETECTION DE DEFAUTS DANS UNE LIGNE DE TRANSMISSION**

VERFAHREN UND VORRICHTUNG ZUR DETEKTION VON FEHLERN IN EINER
ÜBERTRAGUNGSLEITUNG

METHOD AND DEVICE FOR DETECTING FAULTS IN A TRANSMISSION LINE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.06.2017 FR 1755478**

(43) Date de publication de la demande:
**22.04.2020 Bulletin 2020/17**

(73) Titulaire: **Commissariat à l'Énergie Atomique
et aux Énergies Alternatives
75015 Paris (FR)**

(72) Inventeurs:
• **LAYER, Christophe
75015 Paris (FR)**
• **CABANILLAS, Esteban
91400 Orsay (FR)**
• **DUPRET, Antoine
91400 Orsay (FR)**

(74) Mandataire: **Marks & Clerk France
Immeuble "Visium"
22, avenue Aristide Briand
94117 Arcueil Cedex (FR)**

(56) Documents cités:
**EP-A2- 0 675 607      FR-A1- 2 332 741
FR-A1- 2 926 141      US-A- 5 521 512
US-B1- 7 679 371**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## EP 3 639 046 B1

### Description

### Domaine de l'invention

L'invention concerne le domaine des systèmes de diagnostic filaire basés sur le principe de la réflectométrie, en particulier l'invention a pour objet un procédé de détection de défauts dans une ligne de transmission, telle qu'un câble.

### Etat de la technique

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

Le document US5521512 A concerne la réflectométrie dans le domaine temporel, et plus particulièrement un réflectomètre dans le domaine temporel qui utilise des impulsions d'essai successivement retardées et qui entrelace les réflexions échantillonnées pour obtenir un taux d'échantillonnage efficace élevé.

L'invention entre dans le champ d'application des méthodes de diagnostic filaire et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre, pourvu qu'il soit possible d'y injecter un signal de réflectométrie en un point du câble et de mesurer sa réflexion, au même point ou en un autre point.

L'analyse des signaux renvoyés au point d'injection permet d'en déduire des informations sur la présence et la localisation de discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

La précision de la détection de défauts avec des systèmes de diagnostic par analyse de signaux électriques par réflectométrie, dépend de la durée du signal injecté et de la vitesse d'échantillonnage du système de mesure. Pouvoir détecter des défauts avec une grande précision nécessite d'utiliser un signal d'émission à haute fréquence afin que la longueur d'onde du signal injecté coïncide avec les dimensions physiques des défauts dans le câble.

Une méthode connue permettant d'augmenter la précision de la détection de défauts consiste à augmenter la quantité de matériel nécessaire pour effectuer de multiples acquisitions du signal rétro-propagé dans le câble, en déphasant pour chaque acquisition successive, l'horloge d'échantillonnage. Cette méthode apporte des résultats pertinents dans la mesure où le signal injecté dans le câble et mesuré lors des acquisitions successives est stationnaire pendant la durée totale de l'acquisition. Un inconvénient majeur de cette méthode est qu'elle nécessite un temps d'acquisition très important et un traitement des données qui est complexe. Ce temps est déterminé par le nombre de déphasages successifs mais aussi par le temps de déphasage propre aux circuits utilisés pour générer les signaux d'horloge des systèmes numériques d'échantillonnage. Or, ce délai peut être inacceptable pour détecter des défauts intermittents (par exemple un court circuit) dont la durée est courte. Par ailleurs, les moyens nécessaires à l'implémentation de cette méthode sont couteux, notamment pour la mise en œuvre des déphasages du signal d'horloge. En outre, la précision des mesures doit respecter les règles du sur-échantillonnage, et cette méthode nécessite un post-traitement lourd des données pour la recomposition du signal sur-échantillonné. Cette contrainte est d'autant plus complexe quand des composants analogiques sont utilisés pour générer les retards, tels que des « DLL » (pour Delay-Locked Loop) qui sont susceptibles par ailleurs d'introduire des fréquences parasites mais aussi des convertisseurs ou des filtres.

Il est aussi à considérer qu'une chaine de détection de défaut par réflectométrie comporte au moins une conversion numérique-analogique (DAC) du signal à injecter et une conversion analogique-numérique (ADC) du signal à mesurer. Or, les convertisseurs analogiques-numériques à très haute performance qui permettent d'injecter et de mesurer un signal à haute fréquence d'échantillonnage restent couteux. Ils sont donc peu adaptés aux systèmes à bas-coût ou aux méthodes précitées consistant à augmenter le nombre de composants.

Il existe alors le besoin d'une solution appropriée qui palie les inconvénients des solutions connues. La présente invention répond à ce besoin.

**Résumé de l'invention**

Un objet de la présente invention concerne un procédé et un dispositif de détection de défauts dans une ligne de transmission, basé sur l'analyse par réflectométrie, qui permet de manière simple et efficace de recomposer un signal sur-échantillonné.

Avantageusement, le procédé de l'invention offre un procédé de traitement direct des informations en sortie d'un convertisseur analogique numérique d'une chaine d'analyse par réflectométrie, qui permet d'analyser un signal stationnaire sans post traitement pour le recomposer.

Avantageusement, le dispositif de l'invention permet que les convertisseurs DAC et ADC fonctionnent de manière asynchrone.

La présente invention trouvera une application avantageuse dans les systèmes électroniques embarqués où la miniaturisation étant un défi, il convient de limiter le nombre de composants et la consommation électrique afin d'augmenter la durée de vie en fonctionnement des appareils. Ainsi, la présente invention a pour avantage d'offrir une solution à bas coût tout en augmentant la précision des mesures, et est en particulier applicable à la détection de défauts intermittents (de courte durée) pour lesquels les applications actuelles sont démunies à cause de leur faible bande passante.

Avantageusement, la présente invention permet d'augmenter la précision de détection, et ainsi observer des défauts intermittents qui ne sont pas détectables par les systèmes existants.

Ainsi, l'invention apporte sans coût matériel additionnel, une solution permettant :

- d'assurer de manière simple et efficace la recomposition d'un signal sous- ou sur-échantillonné sans post traitement;
- d'augmenter le débit de communications numériques en permettant une synchronisation plus rapide et des temps d'acquisition moins longs ;
- de reconstituer un signal stationnaire quand les convertisseurs DAC et ADC fonctionnent de manière asynchrone;
- d'éliminer des fréquences parasites qui étaient dans les systèmes connus dues aux circuits générateurs de fréquences ou de retard.

Pour obtenir les résultats recherchés, il est proposé un procédé de détection de défaut par réflectométrie dans une ligne de transmission comprenant les étapes suivantes :

- injecter dans la ligne de transmission un signal de référence à une fréquence d'émission $f_{DAC}$;
- récupérer un signal réfléchi en un point de la ligne de transmission ;
- échantillonner le signal réfléchi à une fréquence d'échantillonnage $f_{ADC}$, la fréquence d'échantillonnage $f_{ADC}$ étant différente de la fréquence d'émission $f_{DAC}$ ;
- stocker chaque point du signal échantillonné à une adresse mémoire correspondant à un index affecté audit point du signal échantillonné et selon un incrément d'adressage $\Delta$ précalculé, ledit incrément d'adressage mémoire $\Delta$ étant fonction de la fréquence d'émission $f_{DAC}$, de la fréquence d'échantillonnage $f_{ADC}$, d'un facteur de sur-échantillonnage $\Omega$ et d'un temps d'acquisition $\Sigma$ prédéterminé ;
- répéter l'étape de stockage pendant le temps d'acquisition $\Sigma$ prédéterminé ; et
- générer à partir des points stockés pendant le temps d'acquisition un signal recomposé apte à être utilisé pour détecter des défauts.

Selon différents modes de réalisation :

- l'étape d'échantillonnage comprend une étape consistant à indexer chaque point du signal échantillonné par un index lié à l'index du précédent point de signal échantillonné et à la valeur précalculée de l'incrément d'adressage mémoire $\Delta$;
- le procédé comprend une étape initiale pour calculer l'incrément d'adressage mémoire $\Delta$ ;
- l'incrément d'adressage mémoire $\Delta$ est calculé à partir d'une valeur prédéfinie de la fréquence d'émission $f_{DAC}$ et d'une valeur prédéfinie du facteur de sur-échantillonnage $\Omega$, et où la fréquence d'échantillonnage $f_{ADC}$ et le temps d'acquisition $\Sigma$ sont déterminés en fonction des valeurs prédéfinies de la fréquence d'émission $f_{DAC}$ et du facteur de sur-échantillonnage $\Omega$ ;
- l'incrément d'adressage mémoire $\Delta$ est calculé à partir d'une valeur prédéfinie de la fréquence d'émission $f_{DAC}$ et d'une valeur prédéfinie de la fréquence d'échantillonnage $f_{ADC}$, et où le facteur de sur-échantillonnage $\Omega$ et le temps d'acquisition $\Sigma$ sont déterminés en fonction des valeurs prédéfinies de la fréquence d'émission $f_{DAC}$ et de la fréquence d'échantillonnage $f_{ADC}$ ;
- l'étape de générer un signal recomposé consiste à lire les points du signal échantillonnés stockés aux adresses prédéterminées ;

- le procédé comprend une étape pour produire un réflectogramme ;
- le procédé comprend une étape d'analyse du réflectogramme pour détecter des défauts.

L'invention a également pour objet un système de détection de défaut par réflectométrie dans une ligne de transmission qui comprend des moyens pour mettre en œuvre le procédé revendiqué.

Selon une variante particulière, le système selon l'invention comprend une interface d'affichage pour afficher une information caractéristique de la présence d'un défaut sur la ligne de transmission et/ou de la localisation du défaut.

L'invention a encore pour objet un programme d'ordinateur comportant des instructions pour l'exécution du procédé de détection d'un défaut dans une ligne de transmission selon l'invention, lorsque le programme est exécuté par un processeur et un support d'enregistrement lisible par un processeur sur lequel est enregistré un programme comportant des instructions pour l'exécution du procédé de détection d'un défaut dans une ligne de transmission selon l'invention, lorsque le programme est exécuté par un processeur.

## Description des figures

D'autres caractéristiques et avantages de la présente invention apparaîtront mieux à la lecture de la description qui suit en relation aux dessins annexés qui représentent :

- La figure 1, un schéma d'un système de l'art antérieur de détection de défaut sur une ligne de transmission selon une méthode d'analyse par réflectométrie ;
- La figure 2a, une vue temporelle de la recomposition d'un signal sur-échantillonné par un système de détection de défaut selon la figure 2b ;
- La figure 3, un schéma d'un mode de réalisation du dispositif de détection de défaut sur une ligne de transmission de l'invention ;
- La figure 4, un organigramme représentant des étapes du calcul de l'incrément de stockage des échantillons selon un mode de réalisation de l'invention;
- La figure 5, un organigramme représentant des étapes du procédé de détection de défaut selon un mode de réalisation de l'invention; et
- La figure 6, une vue temporelle de la recomposition directe d'un signal sur-échantillonné selon le procédé de l'invention.

## Description détaillée de l'invention

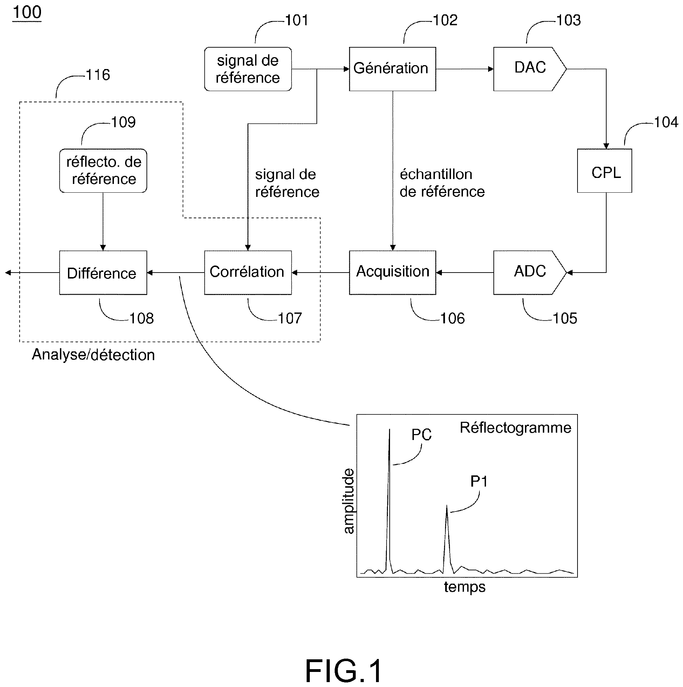

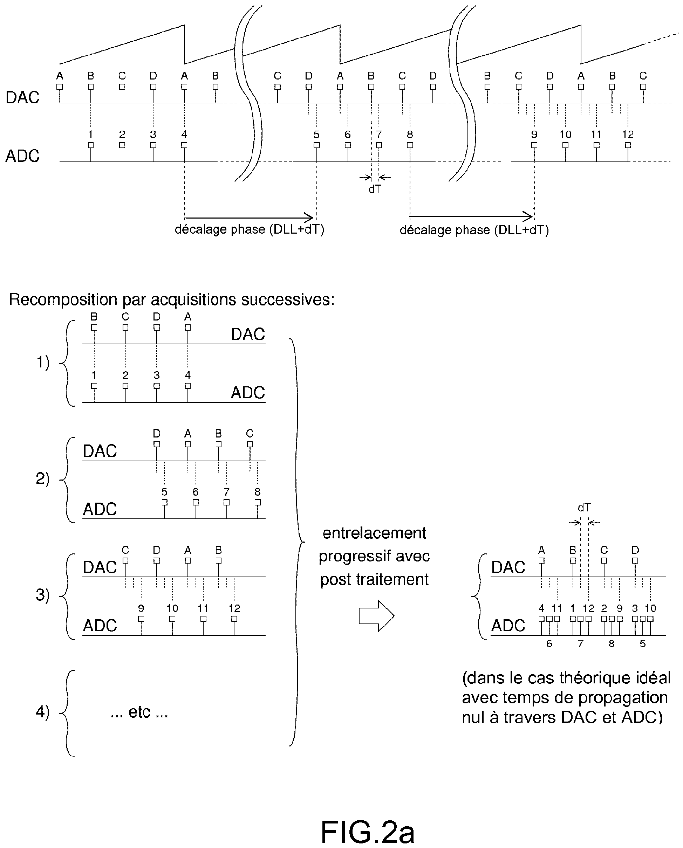

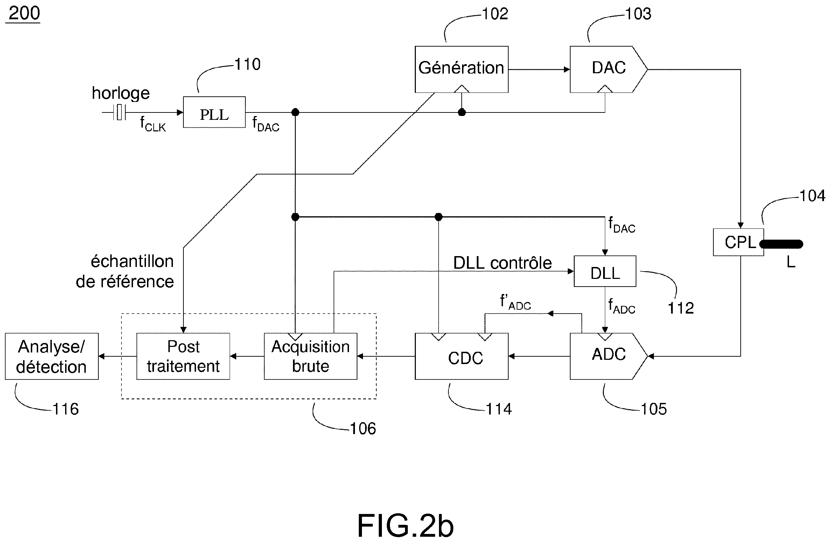

La figure 1 schématise un système 100 connu de l'art antérieur de détection de défauts dans une ligne de transmission, selon un principe d'analyse par réflectométrie. Le système 100 comporte principalement une partie émission constituée d'un générateur 102 pour générer un signal de référence ou de test, à partir de paramètres 101 du signal. Le signal de référence peut être temporel ou fréquentiel. Il peut s'agir d'une simple impulsion temporelle ou d'un signal plus élaboré dans la mesure où celui-ci présente de bonnes propriétés d'autocorrélation, c'est-à-dire que le résultat d'un calcul d'autocorrélation appliqué à ce signal donne un pic d'amplitude significatif qu'il est possible d'identifier et de détecter. Par exemple, le signal utilisé peut être du type OMTDR (Orthogonal Multi-tone Time Domain Reflectometry) ou MCTDR (MultiCarrier Time Domain Reflectometry). Le signal est envoyé à un convertisseur numérique-analogique (DAC) 103 qui permet de convertir le signal de référence numérique en un signal analogique qui est ensuite injecté en un point de la ligne de transmission (non représentée à la figure 1, représenté par « L » sur la figure 2) via un coupleur 104. Le système 100 comporte ensuite une partie réception qui comprend un coupleur 104 (identique au précédent ou distinct) pour récupérer, en un point de la ligne, le signal réfléchi et rétro-propagé dans la ligne de transmission. Le signal récupéré est converti numériquement via un convertisseur analogique-numérique (ADC) 105 qui l'envoie sur un circuit d'acquisition brute et post-traitement 106. Il est effectué un certain nombre d'acquisitions de points du signal réfléchi selon une référence temporelle donnée par un échantillon de référence, avant de remettre en forme le signal par un post-traitement.

Le signal recomposé peut ensuite être analysé (bloc 116) pour détecter d'éventuels défauts. De manière optionnelle, un corrélateur 107 peut être en charge de réaliser une corrélation entre le signal recomposé en sortie du bloc de post-traitement 106 et le signal de référence, pour différents décalages temporels, afin de produire un réflectogramme temporel. Il est à noter que pour les systèmes en TDR simple (Time Domain Reflectometry), un corrélateur n'est pas requis.

Un exemple de réflectogramme temporel est montré sur le bas de la figure 1. Il comporte un certain nombre de pics d'amplitude qui traduisent des discontinuités d'impédance dans la ligne de transmission. Les abscisses temporelles des pics sur le réflectogramme correspondent à des positions dans la ligne de transmission. La relation de conversion entre abscisse temporelle t et position d est donnée par la relation d=V.t où V est la vitesse de propagation du signal dans la ligne. Le réflectogramme obtenu peut être comparé 108 en calculant sa différence par rapport à un réflectogramme de référence 109 pour détecter de potentielles erreurs sur le canal. Sur le réflectogramme donné en exemple à la figure 1, on observe un premier pic Pc correspondant au point d'injection du signal puis un second pic $P_1$ qui correspond à une discontinuité d'impédance qui peut découler d'un défaut électrique sur la ligne. Ainsi, par analyse du réflectogramme, il est possible de déduire la présence et la localisation de défauts dans une ligne de transmission.

Comme illustré sur la figure 2a, pour la détection de défauts intermittents, c'est-à-dire de défauts ayant une existence limitée dans le temps, en général de durée courte, le signal de référence utilisé est un signal stationnaire S, ou plus justement un signal en régime permanent établi, qui est injecté en continu dans le câble L. Le signal stationnaire est, par exemple, composé d'une séquence (A, B, C, D) d'échantillons ayant une durée prédéterminée, cette séquence étant réinjectée successivement de façon périodique T. Simultanément à l'injection du signal, le signal rétropropagé dans le câble est mesuré en continu. Pour améliorer la précision de l'analyse, un sur-échantillonnage du signal réfléchi est réalisé en décalant l'horloge d'échantillonnage du convertisseur analogique numérique toutes les périodes T ou multiples de cette période T. L'acquisition des échantillons reçus (1, 2, 3, 4, ....) sur un certain nombre de périodes permet de recomposer le signal puis procéder à la suite du traitement avec le signal de référence pour détecter des défauts.

L'exemple de la figure 2a représente l'injection et l'échantillonnage d'un signal stationnaire avec deux fréquences identiques pour le DAC et l'ADC. Le décalage (« phase shift » en anglais) de l'instant d'échantillonnage de l'ADC permet de simuler l'échantillonnage à des instants intermédiaires. Comme expliqué précédemment, il n'existe pas de méthode connue ou cohérente pour réordonner sans post-traitement les éléments en sortie de l'ADC de manière sensée ni réellement anticipatoire, dans la mesure où le temps de « phase-shifting » n'est pas connu d'avance, mais est uniquement garanti dans une limite haute et basse. La raison est essentiellement qu'un retard imprédictible est inséré entre deux acquisitions successives, dû au temps de recalage de la DLL, et au temps de propagation des signaux à travers l'ensemble des composants.

La figure 2b illustre une implémentation connue d'un circuit permettant de recomposer un signal stationnaire après avoir décalé, par une DLL 112, l'instant d'échantillonnage du convertisseur analogique numérique (ADC) par rapport à celui du convertisseur numérique analogique (DAC). Il est à noter que les mêmes composants ont les mêmes références sur les figures. Sans plus entrer dans les détails d'implémentation de la gestion des horloges, l'homme du métier comprend que le circuit peut opérer depuis une horloge système « clock » de fréquence $f_{CLK}$ permettant par un composant 110 de type « PLL » de générer une fréquence d'horloge pour synchroniser les différents composants du système. Le décalage de l'instant d'échantillonnage pour l'ADC peut être réalisé à partir de la fréquence d'échantillonnage $f_{DAC}$ du DAC par un composant 112 de type « DLL ». En opération et de manière connue, le signal réfléchi est échantillonné en sortie de l'ADC à la fréquence $f_{ADC}$, un nombre d'échantillons est comptabilisé avant d'être utilisés en post traitement pour reconstituer le signal réfléchi qui sera analysé dans un circuit d'analyse et détection 116. Un inconvénient des implémentations connues est que le circuit d'acquisition brute et de post-traitement 106 est très complexe, il doit entre autre gérer tous les paramètres de déphasage compris dans la DLL (ou tout circuit équivalent pour la gestion de retard temporel). Dans l'exemple illustré, les horloges f_DAC et f_ADC des convertisseurs sont issues d'un même générateur (typiquement de type PLL 110) afin de maitriser les variations des dérives temporelles et fréquentielles. Le bloc d'acquisition brute et de post-traitement 106 doit resynchroniser tous les échantillons sur la base d'un échantillon de référence et les remettre dans l'ordre. Le post-traitement consiste aussi à réaligner les échantillons à l'intérieur d'une même période du DAC, à cause d'un effet de délai, intrinsèque à toute chaine analogique ou à tout changement de domaine (CDC 114), ce problème étant bien connu de l'homme du métier. De plus, le bloc de post-traitement doit gérer le nombre d'échantillons gagnés ou perdus, en fonction de la direction du déphasage, qui après « 2pi » s'est intrinsèquement décalé d'un échantillon de génération (DAC) en plus ou en moins, en fonction du type de DLL utilisée. Pour avoir plus de flexibilité, le post-traitement peut être réalisé par un logiciel spécifique. En contrepartie, le temps de post-traitement est long, et de plus inutilisable dans un système embarqué sans processeur, ou bien avec un processeur moyennement performant, ce qui est en général le cas dans les systèmes embarqués.

Ainsi avantageusement, contrairement à l'art antérieur, le dispositif de l'invention ne met pas en oeuvre de système de retardement d'horloge, ni de boucle d'asservissement, ni de contrôle global, ni de mécanique de recomposition ou d'adressage complexe après l'ADC pour désentrelacer les données.

Le principe nouveau et inventif de l'invention consiste à utiliser des fréquences $f_{DAC}$ et $f_{ADC}$ différentes pour les signaux d'horloge pilotant les convertisseurs DAC et ADC, contrairement à l'état de l'art où les fréquences $f_{DAC}$ et $F_{ADC}$ sont les mêmes mais où les signaux d'horloge pilotant les convertisseurs DAC et ADC sont déphasés.

Grâce à une indexation précalculée, chaque point échantillonné est indexé et stocké à une adresse mémoire qui lui est assignée selon son index et permettant que le signal acquis soit récupéré directement pour l'analyse, sans post-traitement pour le recomposer.

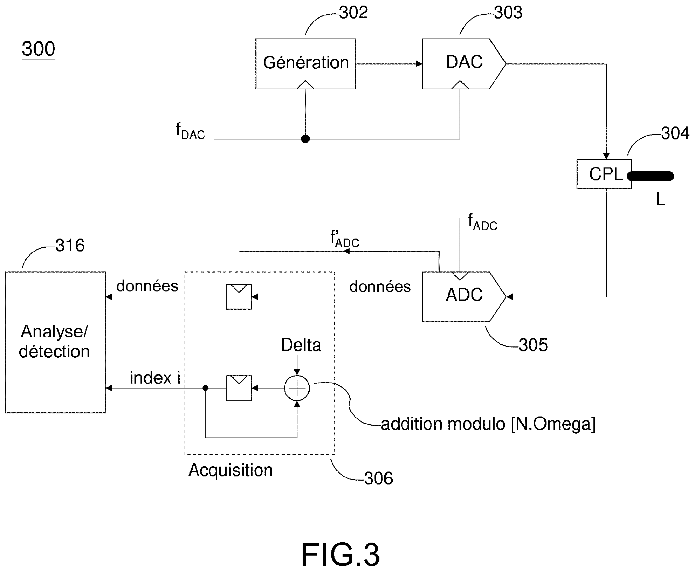

La figure 3 illustre un mode de réalisation du dispositif de l'invention. Le système 300 comporte une partie émission (302, 303, 304) et une partie réception (304, 305, 306). Un bloc d'analyse et de détection de défaut 316 qui n'est pas plus détaillé car pouvant mettre en œuvre des techniques conventionnelles, peut être directement couplé au dispositif de l'invention.

La partie émission est constituée d'un générateur 302 apte à générer un signal de référence (ou de test) envoyé à un convertisseur numérique analogique 303 fonctionnant à une fréquence F$_{DAC}$. Le signal est injecté dans une ligne de transmission L via un coupleur 304. La partie réception est constituée d'un coupleur 304 (identique ou différent du coupleur de l'émission) pour récupérer le signal rétro-propagé qui est converti dans un convertisseur analogique numérique 305 pour échantillonner le signal à une fréquence f$_{ADC}$. Dans une variante de réalisation, la fréquence du DAC et celle de l'ADC peuvent être obtenues depuis la fréquence de l'horloge système par une ou plusieurs PLL.

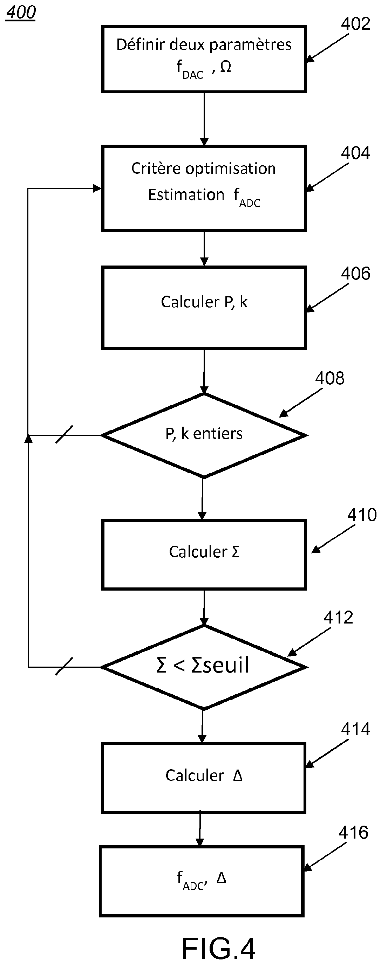

La partie réception du dispositif de l'invention comporte de plus un bloc d'acquisition 306 apte à générer pour chaque échantillon (ou point du signal rétro-propagé) une adresse mémoire pour le stocker. Avantageusement, selon le principe de l'invention et tel que détaillé sur la figure 4, un incrément d'adressage en mémoire est pré-calculé de manière à obtenir directement un signal recomposé, sans post-traitement après l'acquisition des échantillons.

Avantageusement et contrairement aux méthodes connues de l'état de l'art, le bloc acquisition 306 du dispositif de l'invention ne réalise pas de calcul complexe ni de post-traitement pour remettre tous les échantillons dans le bon ordre et générer un signal recomposé.

Dans un mode de réalisation, le bloc acquisition comprend un additionneur pour affecter à chaque échantillon acquis, un index respectif correspondant à une adresse mémoire où le stocker. En opération, chaque échantillon x(t) en sortie du convertisseur ADC est labellisé ($x_i$), sur un index i qui prend l'indice de l'échantillon précédent plus la valeur de l'incrément pré-calculé (Δ), le tout « modulo N. Ω », N étant le nombre de points composant le signal stationnaire injecté par le DAC et Omega (Ω) le facteur de sur-échantillonnage.

Par exemple, pour un échantillon x(t) acquis au temps (t) labellisé à l'index i, l'échantillon suivant acquis au temps (t + T$_{ADC}$) (T$_{ADC}$ étant la période d'acquisition) sera labellisé à l'index (i+Delta)modulo N.Omega :

$$x(t) \rightarrow x_i$$

$$x(t + T_{ADC}) \rightarrow x_{(i+\Delta)\bmod N\Omega}$$

Les échantillons sont acquis pendant un temps d'acquisition prédéfini et sont stockés à des adresses correspondant aux index respectifs selon l'incrément d'adressage pré-calculé.

Le signal disponible en sortie du bloc d'acquisition est directement recomposé et peut être utilisé pour toute analyse par réflectogramme de manière conventionnelle.

La figure 4 montre les étapes 400 pour la détermination de l'incrément Delta selon une première variante de réalisation. Le principe de l'invention permettant une recomposition directe du signal, consiste à déterminer la valeur de l'incrément Delta à appliquer sur les index des échantillons pour l'adressage en mémoire. La valeur de Delta est fonction de plusieurs paramètres : les fréquences opérationnelles des convertisseurs f$_{DAC}$ et f$_{ADC}$, le facteur de sur-échantillonnage Ω, et le temps d'acquisition Σ pour reconstituer un signal de « Omega fois N points ».

Avantageusement, en fixant au moins deux paramètres parmi les quatre, l'algorithme de calcul proposé permet de déterminer la valeur de l'incrément Delta, suivant le raisonnement suivant :
Soit P le plus grand commun diviseur commun (PGCD) de $T_{DAC}$ et $T_{ADC}$ :

$$P = PGCD(k \cdot T_{DAC}; k \cdot T_{ADC})$$

avec une constante k pour que $k \cdot T_{DAC}$ et $k \cdot T_{ADC}$ soient entiers.

P doit être entier, mais il peut ne pas exister selon certaines valeurs de $T_{DAC}$ et $T_{ADC}$.

Aussi, en choisissant $T_{DAC}$ ou $T_{ADC}$, il convient en fait de trouver respectivement $T_{ADC}$ ou $T_{DAC}$ tel que P et k existent et soient entiers, afin d'obtenir le bon facteur de sur-échantillonnage :

$$\exists\, k \geq 1 \in \mathbb{N} \ \& \ \exists\, P \in \mathbb{N} \mid P = PGCD(k \cdot T_{DAC}; k \cdot T_{ADC})$$

Dans la variante de réalisation décrite, dans une première étape 402, la fréquence du DAC f$_{DAC}$ et le facteur de sur-échantillonnage Ω sont choisis. Par exemple, $f_{DAC} = \frac{1}{T_{DAC}}$ est choisie égale à 100 MHz et Ω est choisi égal à 4.

Dans une étape suivante 404, le procédé 400 permet d'estimer une fréquence $f_{ADC} = \frac{1}{T_{ADC}}$ pour le convertisseur ADC. La solution n'étant pas unique, le procédé permet de sélectionner un critère d'optimisation pour les deux autres paramètres. Par exemple, il peut être décidé de trouver la plus grande fréquence de l'ADC tel que $f_{ADC} < f_{DAC}$. Ce critère correspond à des applications concrètes, les ADC coutant plus cher que les DAC, il est en général souhaité de réduire leur fréquence de fonctionnement. Le critère d'optimisation peut être complété en souhaitant que l'acquisition de N points soit la plus courte possible, c'est-à-dire en cherchant à minimiser $\Sigma$.

Le procédé permet de choisir une première valeur pour estimer la fréquence de l'ADC. Dans un mode de réalisation, il peut être choisi d'augmenter la période $T_{ADC}$ de l'ADC, d'un « Omega-ième » de la période $T_{DAC}$ du DAC, Omega étant le facteur de sur-échantillonnage. Dans l'exemple décrit, le procédé commence par le calcul d'une première fréquence selon l'équation suivante : $T_{ADC} = T_{DAC} \cdot \frac{\Omega+1}{\Omega} = 10 \cdot \frac{5}{4} = 12.5 ns$ , donnant une première fréquence pour l'ADC de : $f_{ADC} = 80 MHz$.

L'homme du métier pourrait choisir tout autre point de départ pour fixer une première valeur de la fréquence de l'ADC, tel que choisir une valeur arbitraire mais différente de la fréquence du DAC.

Le procédé permet dans une étape suivante 406 de calculer le PGCD tel que $P = PGCD(k \cdot T_{DAC}; k \cdot T_{ADC})$, puis de vérifier si k et P sont des entiers (étape 408) vérifiant l'équation : $\frac{T_{DAC}}{\Omega} = \frac{P}{k}$ .

Dans l'exemple choisi : $P=PGCD(k.10;k.12.5)$. Le rapport $\frac{T_{DAC}}{\Omega}$ avec k et P entiers peut être vérifié pour :

k = 2 et
P =PGCD(20 ; 25) = 5.

L'homme du métier pourra considérer diverses méthodes connues pour calculer le PGCD, telles que par exemple les divisions successives (méthode d'Euclide).

S'il n'est pas trouvé des valeurs d'entiers pour k et P, le procédé retourne à l'étape 404 pour fixer une nouvelle valeur de la fréquence de l'ADC et répéter les étapes 406 à 408 jusqu'à obtenir des entiers.

Puis le procédé se poursuit à l'étape suivante 410 pour estimer le temps total d'acquisition $\Sigma$ des échantillons pour reconstituer un signal de N points.

Le temps d'acquisition est donné par l'équation : $\Sigma = N \cdot \Omega \cdot T_{ADC}$. Dans l'exemple choisi : $\Sigma = N \cdot 4 \cdot T_{ADC} = N \cdot 4 \cdot 12.5 \ ns = 50 \cdot N \ ns.$

Le procédé permet de comparer le temps d'acquisition à une valeur seuil (étape 412). La valeur seuil peut être prédéfinie et fixe ou adaptée selon l'application. Si le temps d'acquisition obtenu est supérieur au seuil et donc long, le procédé retourne à l'étape 404 pour reconsidérer d'autres valeurs pour la fréquence ADC.

Si le temps d'acquisition est inférieur au seuil, le procédé poursuit à l'étape suivante 414 pour calculer la valeur de l'incrément Delta, tel que :

$$\Delta = k \cdot \frac{T_{ADC}}{P} \ .$$

Dans l'exemple choisi, l'incrément sur les index pour l'adressage en mémoire serait de $\Delta = 5$.

Le procédé se termine (étape 414) en ayant déterminé les valeurs des fréquences des convertisseurs DAC et ADC et la valeur de l'incrément pour stocker les échantillons en mémoire de manière à obtenir directement sans faire de post traitement un signal recomposé.

Le tableau ci-après montre sur différents exemples de fréquences d'échantillonnage pour les convertisseurs DAC et ADC, les valeurs d'incrément $\Delta$ d'adressage mémoire correspondantes.

| $f_{DAC}$ (MHz) | $T_{DAC}$ (ns) | $f_{ADC}$ (MHz) | $T_{ADC}$ (ns) | P, k | $\delta$ (ns) | $\Delta$ | $\Omega$ |
|---|---|---|---|---|---|---|---|
| 50.0 | 20.0 | 40.0 | 25.0 | 5, 1 | 5 | 5 | 4 |
| 100.0 | 10.0 | 40.0 | 25.0 | 5, 1 | 15 | 5 | 2 |
| 100.0 | 10.0 | 33.333 | 30.0 | 10, 1 | 20 | 3 | 1 |
| **100.0** | **10.0** | **80.0** | **12.5** | **5,2** | **2.5** | **5** | **4** |
| 66.667 | 15.0 | 62.745 | 15.937 | 15, 16 | 0.937 | 17 | 16 |

Bien que la figure 4 décrive une variante de réalisation pour la détermination de l'incrément d'adressage, où les deux paramètres fixés initialement sont la fréquence du DAC $f_{DAC}$ et le facteur de sur-échantillonnage $\Omega$, le procédé peut être déroulé de manière équivalente en fixant comme paramètres la fréquence du DAC $f_{DAC}$ et la fréquence de l'ADC $f_{ADC}$. En estimant les valeurs du facteur de sur-échantillonnage et du temps d'acquisition relativement à des valeurs de P et k, la valeur de l'incrément mémoire est calculée.

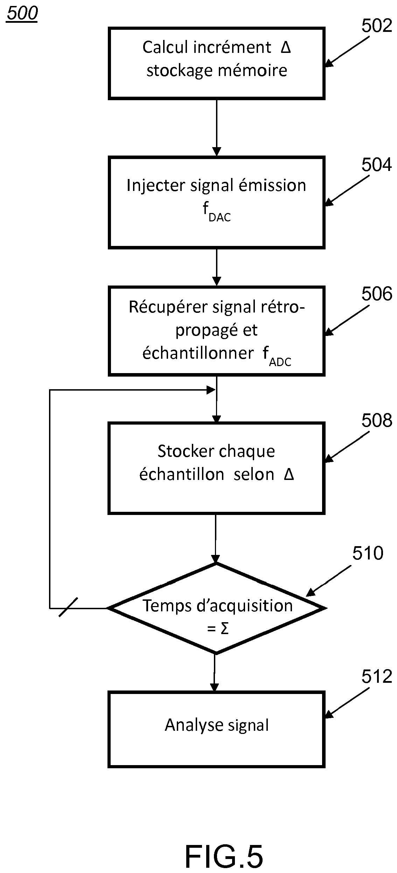

La figure 5 résume les étapes de mise en œuvre du procédé 500 de détection d'un défaut selon l'invention. Le procédé peut être opéré sur un dispositif tel que celui de la figure 3.

Dans une première étape 502, le procédé détermine la valeur de l'incrément Delta selon l'algorithme décrit en référence à la figure 4. Il est à noter que cette étape peut être faite de manière dissociée du test d'une ligne et le procédé récupère alors les paramètres préalablement calculés.

Dans une étape suivante 504, un signal d'émission est injecté en un point d'injection d'une ligne de transmission L à la fréquence $f_{DAC}$ du convertisseur numérique analogique. Dans une étape suivante 506, le signal rétro-propagé dans la ligne L est récupéré et échantillonné à la fréquence du convertisseur analogique numérique $f_{ADC}$.

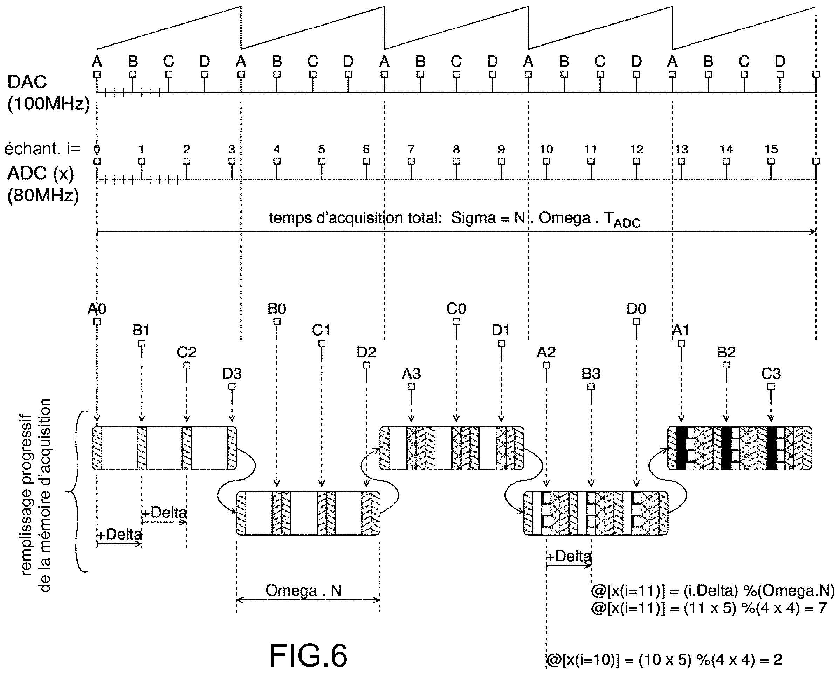

A l'étape suivante 508, le procédé permet de stocker chaque échantillon (ou point du signal) à une adresse prenant en compte la valeur de l'incrément qui a été calculé. La figure 6 illustre une vue temporelle de la recomposition directe d'un signal sur-échantillonné selon le procédé de l'invention pour l'exemple choisi d'une fréquence du DAC de 100 MHz, une fréquence de l'ADC de 80 MHz et un incrément d'adressage $\Delta$ de 5.

Le procédé détermine quand le temps d'acquisition $\Sigma$ est atteint (étape 510) pour poursuivre avec l'analyse du signal (étape 512).

Dans une étape ultérieure (non illustrée), un diagnostic peut être produit quant à la présence d'un défaut et à sa position mesurée sur le réflectogramme R(t). Le résultat du diagnostic peut être fourni à un utilisateur au travers d'une interface d'affichage. Le résultat affiché peut comprendre une indication de la présence d'un défaut sur la ligne et/ou une indication sur la position du défaut sur la ligne.

Le système selon l'une quelconque des variantes de réalisation de l'invention peut être mis en œuvre par une carte électronique sur laquelle sont disposés les différents composants. La carte peut être connectée au câble à analyser par un moyen de couplage CPL qui peut être un coupleur directionnel à effet capacitif ou inductif ou encore une connexion ohmique. Le dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

En outre, une unité de traitement, de type ordinateur, assistant numérique personnel ou autre dispositif électronique ou informatique équivalent, peut être utilisée pour piloter le système selon l'invention et afficher les résultats des calculs sur une interface homme-machine, en particulier les informations de détection et localisation de défauts sur le câble.

Le procédé selon l'invention peut être implémenté dans un processeur embarqué ou non ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le procédé selon l'invention peut également être mis en œuvre exclusivement en tant que programme d'ordinateur, le procédé étant alors appliqué à une mesure de signal préalablement acquise à l'aide d'un dispositif de mesure. Dans un tel cas, l'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing*"), éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

## Revendications

1. Procédé de détection de défaut par réflectométrie dans une ligne de transmission (L) comprenant les étapes de :

   - injecter dans la ligne de transmission un signal de référence à une fréquence d'émission $f_{DAC}$;
   - récupérer un signal réfléchi en un point de la ligne de transmission ;
   - échantillonner le signal réfléchi à une fréquence d'échantillonnage $f_{ADC}$, la fréquence d'échantillonnage $f_{ADC}$ étant différente de la fréquence d'émission $f_{DAC}$ ;
   - stocker chaque point du signal échantillonné à une adresse mémoire correspondant à un index affecté audit point du signal échantillonné et selon un incrément d'adressage mémoire $\Delta$ précalculé, ledit incrément d'adressage mémoire $\Delta$ étant fonction de la fréquence d'émission $f_{DAC}$, de la fréquence d'échantillonnage $f_{ADC}$, d'un facteur de sur-échantillonnage $\Omega$ et d'un temps d'acquisition $\Sigma$ prédéterminé;
   - répéter l'étape de stockage pendant le temps d'acquisition $\Sigma$ ; et
   - générer à partir des points stockés pendant le temps d'acquisition un signal recomposé apte à être utilisé pour détecter des défauts.

2. Procédé selon la revendication 1 dans lequel l'étape d'échantillonnage comprend une étape consistant à indexer chaque point du signal échantillonné par un index lié à l'index du précédent point de signal échantillonné et à la valeur précalculée de l'incrément d'adressage mémoire $\Delta$.

3. Procédé selon la revendication 1 ou 2 comprenant une étape initiale pour calculer l'incrément d'adressage mémoire $\Delta$.

4. Procédé selon la revendication 3 dans lequel l'incrément d'adressage mémoire $\Delta$ est calculé à partir d'une valeur prédéfinie de la fréquence d'émission $f_{DAC}$ et d'une valeur prédéfinie du facteur de sur-échantillonnage $\Omega$, et où la fréquence d'échantillonnage $f_{ADC}$ et le temps d'acquisition $\Sigma$ sont déterminés en fonction des valeurs prédéfinies de la fréquence d'émission $f_{DAC}$ et du facteur de sur-échantillonnage $\Omega$.

5. Procédé selon la revendication 3 dans lequel l'incrément d'adressage mémoire $\Delta$ est calculé à partir d'une valeur prédéfinie de la fréquence d'émission $f_{DAC}$ et d'une valeur prédéfinie de la fréquence d'échantillonnage $f_{ADC}$, et où le facteur de sur-échantillonnage $\Omega$ et le temps d'acquisition $\Sigma$ sont déterminés en fonction des valeurs prédéfinies de la fréquence d'émission $f_{DAC}$ et de la fréquence d'échantillonnage $f_{ADC}$.

6. Procédé selon l'une quelconque des revendications précédentes dans lequel l'étape de générer un signal recomposé consiste à lire les points du signal échantillonné stockés aux adresses prédéterminées.

7. Procédé selon l'une quelconque des revendications précédentes comprenant de plus une étape pour produire un réflectogramme.

8. Procédé selon la revendication 7 comprenant de plus une étape d'analyse du réflectogramme pour détecter des défauts.

9. Système de détection de défaut par réflectométrie dans une ligne de transmission (L) comprenant des moyens pour mettre en œuvre le procédé selon l'une quelconque des revendications 1 à 8.

10. Système de détection de défaut selon la revendication 9 comprenant une interface d'affichage pour afficher une information caractéristique de la présence d'un défaut sur la ligne de transmission et/ou de la localisation du défaut.

11. Programme d'ordinateur comportant des instructions qui conduisent le système selon les revendications 9 ou 10 à exécuter les étapes du procédé de détection de défaut dans une ligne de transmission selon l'une quelconque des revendications 1 à 8, lorsque le programme est exécuté par un processeur.

12. Support d'enregistrement lisible par un processeur sur lequel est enregistré le programme selon la revendication 11.

**Patentansprüche**

1. Verfahren zum Erkennen von Fehlern durch Reflektometrie in einer Übertragungsleitung (L), das die folgenden Schritte umfasst:

   - Einspeisen eines Referenzsignals bei einer Sendefrequenz $f_{DAC}$ in die Übertragungsleitung;
   - Wiederherstellen eines an einem Punkt der Übertragungsleitung reflektierten Signals;
   - Abtasten des reflektierten Signals bei einer Abtastfrequenz $f_{DAC}$, wobei sich die Abtastfrequenz $f_{DAC}$ von der Sendefrequenz $f_{DAC}$ unterscheidet;
   - Speichern jedes Punkts des abgetasteten Signals bei einer Speicheradresse, die einem Index entspricht, der dem Punkt des abgetasteten Signals zugeordnet ist, und gemäß einem vorberechneten Speicheradressierungsinkrement $\Delta$, wobei das Speicheradressierungsinkrement $\Delta$ eine Funktion der Sendefrequenz $f_{DAC}$, der Abtastfrequenz $f_{DAC}$, eines Überabtastungsfaktors $\Omega$ und einer vorbestimmten Erfassungszeit $\sum$ ist;
   - Wiederholen des Speicherschritts während der Erfassungszeit $\sum$; und
   - Erzeugen, aus den während der Erfassungszeit gespeicherten Punkte, eines rekonstituierten Signals, das zum Erkennen von Fehlern benutzt werden kann.

2. Verfahren nach Anspruch 1, wobei der Abtastschritt einen Schritt bestehend aus dem Indexieren jedes abgetasteten Punkts des Signals mit einem Index umfasst, der sich auf den Index des vorherigen abgetasteten Signalpunkts und den vorberechneten Wert des Speicheradressierungsinkrements $\Delta$ bezieht.

3. Verfahren nach Anspruch 1 oder 2, das einen anfänglichen Schritt zum Berechnen des Speicheradressierungsinkrements $\Delta$ umfasst.

4. Verfahren nach Anspruch 3, wobei das Speicheradressierungsinkrement $\Delta$ aus einem vordefinierten Wert der Sendefrequenz $f_{DAC}$ und einem vordefinierten Wert des Überabtastungsfaktors $\Omega$ berechnet wird, und wobei die Abtastfrequenz $f_{DAC}$ und die Erfassungszeit $\sum$ in Abhängigkeit von den vordefinierten Werten der Sendefrequenz $f_{DAC}$ und des Überabtastungsfaktors $\Omega$ bestimmt werden.

5. Verfahren nach Anspruch 3, wobei das Speicheradressierungsinkrement $\Delta$ aus einem vordefinierten Wert der Sendefrequenz $f_{DAC}$ und einem vordefinierten Wert der Abtastfrequenz $f_{DAC}$ berechnet wird, und wobei der Überabtastungsfaktor $\Omega$ und die Erfassungszeit $\sum$ in Abhängigkeit von den vordefinierten Werten der Sendefrequenz $f_{DAC}$ und der Abtastfrequenz $f_{DAC}$ bestimmt werden.

6. Verfahren nach einem der vorherigen Ansprüche, wobei der Schritt des Erzeugens eines rekonstituierten Signals darin besteht, die an den vorbestimmten Adressen gespeicherten abgetasteten Punkte des Signals zu lesen.

7. Verfahren nach einem der vorherigen Ansprüche, das zudem einen Schritt zum Produzieren eines Reflektogramms umfasst.

8. Verfahren nach Anspruch 7, das zudem einen Schritt des Analysierens des Reflektogramms zum Erkennen von Fehlern umfasst.

9. System zur Fehlererkennung durch Reflektometrie in einer Übertragungsleitung (L) umfassend Mittel zum Durchführen des Verfahrens nach einem der Ansprüche 1 bis 8.

10. Fehlererkennungssystem nach Anspruch 9 umfassend eine Anzeigeschnittstelle zum Anzeigen einer Information, die für das Vorliegen eines Fehlers auf der Übertragungsleitung und/oder den Ort des Fehlers charakteristisch sind.

11. Computerprogramm mit i Befehlen, die bewirken, dass das System nach Anspruch 9 oder 10 die Schritte des Fehlererkennungsverfahrens in einer Übertragungsleitung nach einem der Ansprüche 1 bis 8 durchführt, wenn das Programm von einem Prozessor ausgeführt wird.

12. Prozessorlesbares Aufzeichnungsmedium, auf dem das Programm nach Anspruch 11 aufgezeichnet ist.

**Claims**

1. A method for detecting faults in a transmission line (L) by reflectometry, comprising the steps of:

   - injecting into the transmission line a reference signal at an emission frequency $f_{DAC}$;
   - collecting a reflected signal at a point on the transmission line;
   - sampling the reflected signal at a sampling frequency $f_{ADC}$, the sampling frequency $f_{ADC}$ being different from the emission frequency $f_{DAC}$;
   - storing each point of the sampled signal at a memory address corresponding to an index assigned to said point of the sampled signal and according to a precomputed memory-address increment $\Delta$, said memory-address increment $\Delta$ depending on the emission frequency $f_{DAC}$, on the sampling frequency $f_{ADC}$, on an over-sampling factor $\Omega$ and on a preset acquisition time $\Sigma$;
   - repeating the storing step during the acquisition time $\Sigma$; and
   - generating, from the points stored during the acquisition time, a recomposed signal able to be used to detect faults.

2. The method according to claim 1, wherein the sampling step comprises a step consisting in indexing each point of the sampled signal with an index related to the index of the preceding point of the sampled signal and to the precomputed value of the memory-address increment $\Delta$.

3. The method according to claim 1 or 2, comprising an initial step for computing the memory-address increment $\Delta$.

4. The method according to claim 3, wherein the memory-address increment $\Delta$ is computed from a predefined value of the emission frequency $f_{DAC}$ and from a predefined value of the over-sampling factor $\Omega$, and wherein the sampling frequency $f_{ADC}$ and the acquisition time $\Sigma$ are determined depending on the predefined values of the emission frequency $f_{DAC}$ and of the over-sampling factor $\Omega$.

5. The method according to claim 3, wherein the memory-address increment $\Delta$ is computed from a predefined value of the emission frequency $f_{DAC}$ and from a predefined value of the sampling frequency $f_{ADC}$, and wherein the over-sampling factor $\Omega$ and the acquisition time $\Sigma$ are determined depending on the predefined values of the emission frequency $f_{DAC}$ and of the sampling frequency $f_{ADC}$.

6. The method according to any one of the preceding claims, wherein the step of generating a recomposed signal consists in reading the points of the sampled signal stored at the predetermined addresses.

7. The method according to any one of the preceding claims, in addition comprising a step for producing a reflectogram.

8. The method according to claim 7, in addition comprising a step of analyzing the reflectogram with a view to detecting faults.

9. A system for detecting faults in a transmission line (L) by reflectometry, comprising means for implementing the method according to any one of claims 1 to 8.

10. The system for detecting faults according to claim 9, comprising a display interface for displaying an information characteristic of the presence of a fault on the transmission line and/or of the location of the fault.

11. A computer program containing i instructions which lead the system according to claims 9 or 10 to execute the steps of the method for detecting faults in a transmission line according to any one of claims 1 to 8, when the program is executed by a processor.

12. A processor-readable storage medium on which is stored the program according to claim 11.

FIG.1

FIG.2a

FIG.2b

FIG.3

EP 3 639 046 B1

_400_

```
              ┌──────────────────────────┐        402
              │  Définir deux paramètres │ ◄─────
              │      f_DAC , Ω            │
              └──────────────────────────┘
                          │
                          ▼
    ┌────►  ┌──────────────────────────┐        404
    │       │   Critère optimisation   │ ◄─────
    │       │    Estimation  f_ADC     │
    │       └──────────────────────────┘
    │                   │
    │                   ▼
    │       ┌──────────────────────────┐        406
    │       │      Calculer P, k       │ ◄─────
    │       └──────────────────────────┘
    │                   │
    │                   ▼                        408
    │              ╱─────────╲         ◄─────
    ├──────/──────│  P, k entiers │
    │              ╲─────────╱
    │                   │
    │                   ▼
    │       ┌──────────────────────────┐        410
    │       │       Calculer Σ         │ ◄─────
    │       └──────────────────────────┘
    │                   │
    │                   ▼                        412
    │              ╱─────────╲         ◄─────
    └──────/──────│ Σ < Σseuil │
                   ╲─────────╱
                        │
                        ▼
            ┌──────────────────────────┐        414
            │       Calculer  Δ        │ ◄─────
            └──────────────────────────┘
                        │
                        ▼
            ┌──────────────────────────┐        416
            │       f_ADC,  Δ          │ ◄─────
            └──────────────────────────┘
```

$$\text{FIG.4}$$

_500_

502

Calcul incrément Δ
stockage mémoire

504

Injecter signal émission
$f_{DAC}$

506

Récupérer signal rétro-
propagé et
échantillonner $f_{ADC}$

508

Stocker chaque
échantillon selon Δ

510

Temps d'acquisition
= Σ

512

Analyse signal

## FIG.5

EP 3 639 046 B1

DAC
(100MHz)

A  B  C  D  A  B  C  D  A  B  C  D  A  B  C  D  A  B  C  D

échant. i=  0     1     2     3     4     5     6     7     8     9     10    11    12    13    14    15
ADC (x)
(80MHz)

temps d'acquisition total: Sigma = N . Omega . $T_{ADC}$

A0

B0

C0

D0

B1

C1

D1

A1

C2

D2

A2

B2

D3

A3

B3

C3

remplissage progressif
de la mémoire d'acquisition

+Delta

+Delta

Omega . N

+Delta

@[x(i=11)] = (i.Delta) %(Omega.N)
@[x(i=11)] = (11 x 5) %(4 x 4) = 7

FIG.6

@[x(i=10)] = (10 x 5) %(4 x 4) = 2

**EP 3 639 046 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5521512 A